# EUROPEAN PATENT SPECIFICATION

(11) **EP 0 627 767 B1**
(45) Date of publication and mention of the grant of the patent: **06.11.2002**
(21) Application number: 94112898.5
(22) Date of filing: 21.04.1989
(51) Int. Cl.: H01L 27/06, H01L 21/82

(54) **Process for fabricating JFET transistors and capacitors**
Verfahren zur Herstellung von JFET-Transistoren und Kondensatoren
Procédé pour l'intégration de JFETs et de capacités

(30) Priority: 27.06.1988 US 211641
(43) Date of publication of application: 07.12.1994
(62) Divisional of application: 89107212.6
(73) Proprietor: TEXAS INSTRUMENTS INCORPORATED, Dallas Texas 75265 (US)
(72) Inventor: Seacrist, Michael R., Grapevine, Texas 76051 (US); Trogolo, Joe R., Plano, Texas 75023 (US); Bell, Kenneth M., Windom, Texas 75492 (US)
(74) Representative: Schwepfinger, Karl-Heinz, Dipl.-Ing.

(56) References cited:
- EP-A- 0 006 119
- EP-A- 0 032 700
- US-A- 4 419 812
- ELEKTROTECHNIK UND MASCHINENBAU, vol.85, no.10, 1968, WIEN AT pages 461 - 465 H.B. OEVE ET AL 'Integrierte Schaltungen in der industriellen Elektronik'
- MICROELECTRONICS JOURNAL, vol.13, no.4, July 1982, LUTON GB pages 29 - 36 R.L MADDOX 'Fabrication process techniques for switched-capacitor filter circuits'
- ELEKTRONIK, vol.26, no.11, 1977, MUNCHEN DE page 22 'La technologie BIFET'
- ELECTRONICS., vol.61, no.17, November 1988, NEW YORK US pages 125 - 128, XP118485 S. WEBER 'TI's new linear process powers an advanced family of Op. Amps.'

## Description

### TECHNICAL FIELD OF THE INVENTION

This invention relates in general to the fabrication of different integrated circuit devices using a single semiconductor substrate, and more particularly to a process for simultaneously fabricating a junction field effect transistor (JFET) and a capacitor.

### BACKGROUND OF THE INVENTION

Operational amplifier designs have always been limited in that conventional PNP integrated circuit transistors used therefor can operate only to around 5 megahertz. These PNP transistors in combination with conventional NPN transistors are typical devices found in operational amplifier integrated circuits.

Recently, a high-frequency isolated vertical PNP (VPNP) transistor has been developed that is superior to the conventional and substrate PNP transistors. This isolated VPNP transistor is capable of 45-volt operation and exhibits a maximum operating frequency around 150 megahertz. The current gain and breakdown voltages on the isolated VPNP transistor are comparable to those achieved on the standard double diffused NPN transistor. Finally, the isolated VPNP is not limited to the emitter-follower configuration taken by the normal vertical substrate PNP transistor.

Separately, a 50-volt (p) channel JFET has been developed to extend the gate-to-drain breakdown voltage past 45 volts. JFETs of this kind are conventionally used as operational amplifier inputs. These JFETs are achieved by using a thick deposited oxide over the gate oxide to reduce the electric field intensification at the top gate/drain reverse-biased p-n junction. This increases the gate-to-drain breakdown voltage from the low 30 volt range to approximately 50 volts. The gate-to-drain and gate-to-source oxides overlap capacitances are also reduced with the deposited oxide. This contributes to higher bandwidths and slew rates.

Another desirable integrated circuit component is the metal/nitride/poly capacitor. The use of nitride in the place of oxide provides a doubling of the capacitance and allows for a dielectric breakdown in excess of 100 volts, and the fabrication of these capacitors on field oxide reduces parasitic junction capacitance and tank leakage currents.

From Elektrotechnik und Maschinenbau, vol. 85, no. 10, 1968, pgs. 461-465, a monolithic integrated circuit including an NPN transistor, an (n) channel junction field effect transistor, a resistor and a capacitor formed within an (n) type layer on a (p) type substrate is known. The layers of the circuit are formed by diffusing dopants of different conductivity types into the silicon substrate. Heavily (p) doped junction isolation regions, which reach down into the substrate, are formed between the devices. An oxide layer having contact orifices is formed on the surface of the circuit.

From EP-A-0 006 119 a process is known for the formation of an NPN transistor on a (p) type substrate merged with a JFET. The devices are formed in an epitaxial layer.

From US-A-4 419 812 a method is known for the formation of a conductive polysilicon parallel plate capacitor and a polysilicon gate enhancement mode transistor for a voltage multiplier on a semiconductive substrate of a first conductivity type having an active region of a second conductivity type and a field isolation oxide region.

In Microelectronics Journal, vol.13, no. 4, July 1982, pgs. 29 to 36, different capacitor structures that are integratable to a production NMOS or N well CMOS process are described. In one category of capacitor structure, the lower capacitor plate, which is made of polysilicon, is situated over a 1 µm thick field oxide. The upper plate is made of aluminum. The dielectric layer is an oxide layer or an oxide-nitride sandwich.

It is therefore desirable to develop a process for the fabrication of an integrated circuit including a JFET and a capacitor of the kind described above. As yet, no such process has been heretofore developed, limiting circuit designers to the use of one of these circuit devices without the others in any one integrated circuit.

### SUMMARY OF THE INVENTION

One aspect of the present invention comprises a process for the simultaneous fabrication of a junction field effect transistor (JFET) and a capacitor using a single semiconductor substrate comprising the steps defined in claim 1.

The incorporation of the fabrication steps of these devices into a single process flow has the advantage of greatly reducing the number of mask levels required for the separate fabrication of each. An integrated circuit containing these devices gives integrated circuit designers much more leeway and flexibility than the more conventional devices that they supplement. The process is compatible with more conventional 45 volt vertical NPN transistors, high sheet resistors, 45 volt threshold voltages, and other common features of JFET fabrication processes. The double (up and down) diffused isolation preferably used in the construction of the devices of the invention allows for a tighter design layout and can save up to 25% layout area on spacing relative to single-diffusion isolation.

### BRIEF DESCRIPTION OF THE DRAWINGS

Other aspects of the invention and their advantages will become apparent by referring to the following detailed description in conjunction with the drawings in which:
FIGURES 1-4 are greatly enlarged schematic sections showing successive stages of fabricating a vertical PNP transistor, a p-channel JFET and a vertical NPN transistor useful for understanding the present invention;
FIGURE 3a is a detail of the sectional view shown in FIGURE 3, showing additional JFET fabrication steps; and
FIGURE 5 is a greatly enlarged schematic sectional view of a metal/nitride/polysilicon capacitor that is fabricated in conjunction with the devices shown in FIGURES 1-4.

### DETAILED DESCRIPTION OF THE INVENTION

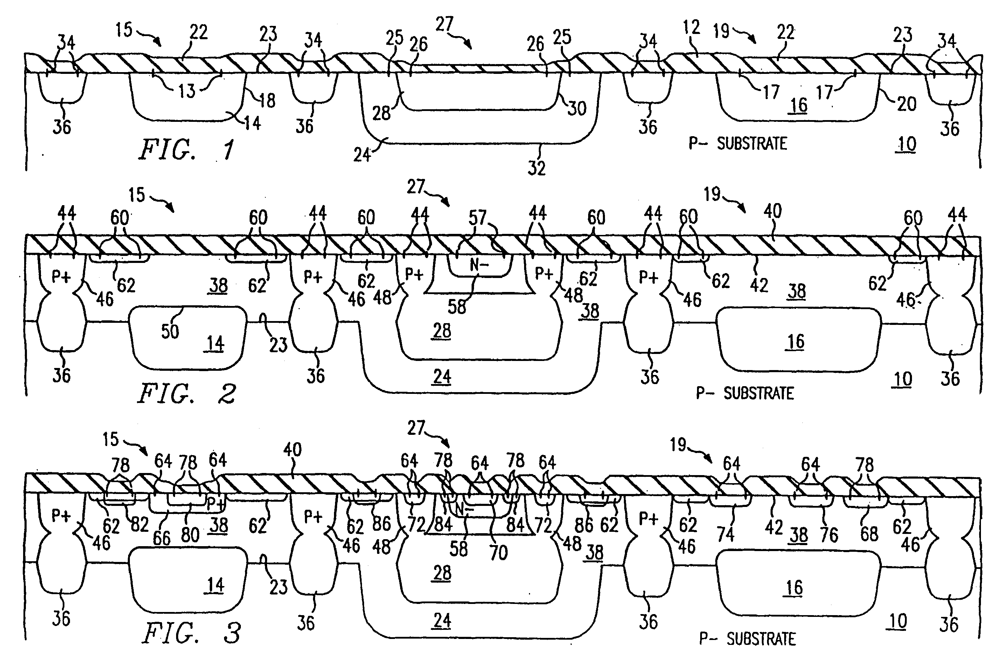

Referring first to FIGURE 1, a (p-) silicon substrate 10 is shown in a greatly enlarged and schematic view. Silicon substrate 10 may have either (100) or (111) crystallographic orientation, although (100) orientation is preferred. An initial oxide layer 12, here shown after several patternings, etches and regrowths of replacement oxide, is grown on substrate 10. After this, a portion of oxide layer 12 between limits 13 (schematically shown by hash marks) is removed using conventional pattern-and-etch techniques to create a mask for the implantation of an (n+) buried collector region 14 for an NPN vertical transistor in an NPN bipolar transistor area indicated generally at 15. At the same time, an (n+) buried region 16 is masked in oxide layer 12 to limits 17 in a (p) channel JFET area of the substrate indicated generally at 19. The sheet resistance of the buried collector region 14 and JFET buried region 16 should be approximately 15 Ohms/square, and a preferred dopant is antimony.

After the implantation of the dopant, substrate 10 is subjected to a thermal diffusion step to give the respective approximate conductivity type boundaries 18 and 20 of the buried regions 14 and 16 as shown. During this and subsequent thermal diffusion steps, oxide portions, such as portions 22, will grow back wherever the outer surface 23 of the silicon substrate 10 has been exposed before the previous implantation step.

Next, oxide layer 12 is removed within limits 25 and an (n-) buried region 24 is implanted and thermally diffused within a vertical PNP transistor area indicated generally at 27. The dopant concentration used to implant buried region 24 is much less than that of collector region 14 and JFET buried region 16, as using the same dopant level would overwhelm the vertical PNP collector region subsequently formed and described immediately below.

In a similar manner, -the oxide layer 12 is again removed within limits 26 to mask an implantation step for forming a (p) vertical PNP transistor collector region 28. A preferred implanted dopant species is boron. The (p) dopant is diffused by means of a thermal cycle such that the approximate final limit between (p) type and (n) type material is marked by boundary 30. The distance between boundary 30 of VPNP transistor collector region 28 and the boundary 32 of buried region 24 must be sufficient to isolate collector region 28 from the (p-) substrate 10, and to withstand more than the maximum operating voltage potential and not have a punch-through voltage breakdown.

Simultaneously with the removal of oxide from layer 12 within limits 26, oxide is removed within limits 34 such that the (p) type dopant implanted into region 28 will also be implanted into a plurality of deep junction isolation regions 36. Regions 36 are provided to isolate the devices from each other such that parasitic transistor devices will not be formed.

Turning now to FIGURE 2, oxide layer 12 is stripped and an (n-) epitaxial silicon layer 38 is grown on the surface 23 of semiconductor substrate 10. A second oxide layer 40 is grown from an outer surface 42 of epitaxial layer 38.

Oxide layer 40 is next removed within limits 44 to provide a mask for the next implantation step, which is a heavy deposition of (p) type dopant. The (p) dopant is diffused in a subsequent thermal cycle to create shallow (p+) junction isolation regions 46 and a (p+) deep collector region 48. Each shallow isolation region 46 overlies a respective deep isolation region 36, and region 48 overlies VPNP buried collector region 28. Deep collector region 48 is preferably annular or otherwise endless.

The deposition of the (p) dopant is followed by a thermal diffusion drive-in step such that shallow junction isolation regions 46 become continuous with deep junction isolation regions 36, and such that deep collector region 48 will become continuous with buried collector region 28. In this diffusion step, dopant diffuses upwardly from semiconductor substrate 10 at the same time that dopant diffuses downwardly from the surface of epitaxial layer 38. This up-diffusion establishes upper boundaries 50 of collector regions 14 and 16 and upper boundary 52 of VPNP collector region 28.

In the various diffusion steps conducted, it is important to balance the thermal cycles in order to get the proper amount of diffusion. Hence, earlier-created structures should be subjected to a less severe thermal cycle than later-created structures if all other parameters are the same, because the later thermal cycles will affect the extent and concentrations of earlier created structures as well as the later ones.

Next, oxide layer 40 is removed within limits 57 and an (n) type dopant is implanted therein to form an (n-) base region 58 for the VPNP transistor. Subsequently, oxide layer 40 is removed within limits 60 to permit the implantation of an (n) type dopant such as antimony. After this implantation, a thermal diffusion drive-in step is conducted on epitaxial layer 38 such that the (n) type dopant implanted between limits 57 and between limits 60 diffuses to create threshold adjust regions 62 and to set VPNP base region 58. Threshold adjust regions 62 are desirable to prevent parasitic PMOS transistors between (p) diffusions, such as diffused regions 46 and 48. Threshold adjust regions 62 control the junction breakdown voltage such that it can exceed the standard 45-volt operating voltage.

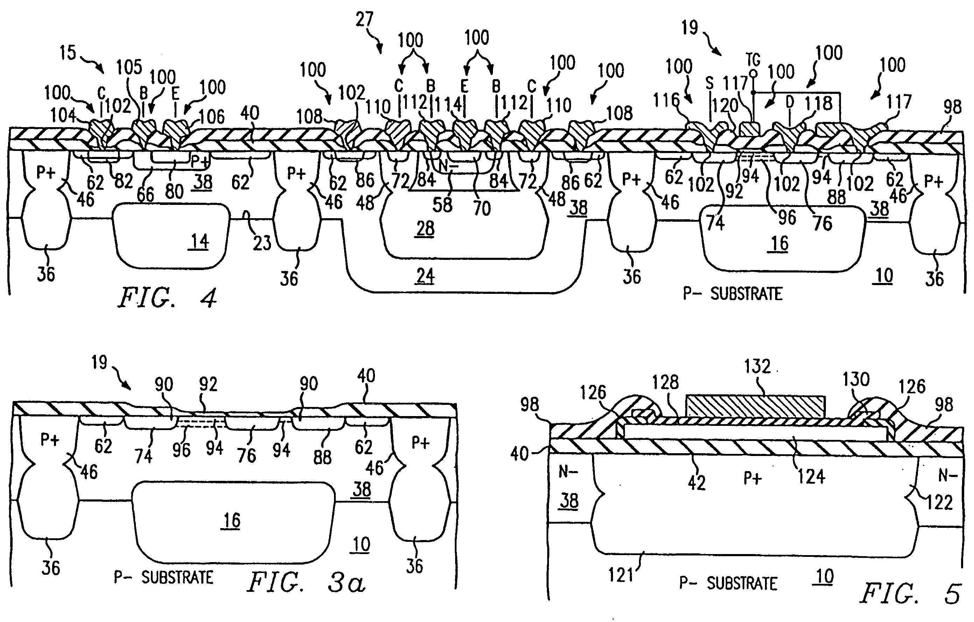

Turning now to FIGURE 3, a portion of oxide layer 40 is removed within limits 64 in NPN transistor area 15, VPNP transistor area 27, and JFET area 19. Then, a (p) type dopant is deposited and thermally diffused to create a (p+) NPN transistor base region 66, a VPNP transistor (p+) emitter region 70, an annular or endless (p+) contact region 72 inside VPNP deep collector region 48, a (p+) JFET source region 74 and a (p+) JFET drain region 76. After this step, high sheet resistance resistors (not shown) may be patterned by removal of certain portions of oxide layer 40 (not shown) with a subsequent oxidation and implantation to create the resistors (not shown) in layer 38.

Next, oxide is removed from oxide layer 40 down to the surface 42 of the epitaxial layer 38 within limits 78 in all three device areas 15, 19 and 27 for masking the deposition of an (n) type dopant. The dopant thus deposited is subsequently thermally diffused to create a conventional vertical NPN emitter region 80, a collector contact region 82 for the conventional NPN transistor, a vertical PNP base contact region 84, a'buried region contact 86 for ohmic contact to buried region 24, and a JFET gate contact region 88. In the embodiment shown, base contact region 84 is annular or otherwise endless.

To illustrate further steps in the fabrication of the JFET, a sectional detailed view is shown in FIGURE 3a. Field oxide 40 is removed between limits 90 and a thin gate oxide 92 is grown over the exposed surface of epitaxial layer 38. An (n) type dopant, preferably phosphorus, is next implanted through gate oxide 92 to ,form a top gate region 94 that extends from gate contact region 88 to both source region 74 and drain region 76. After this implantation step, a layer of photoresist (not shown) is used to mask all areas of gate oxide 92 except a window extending from drain region 76 to source region 74. This remaining exposed area is subjected to a boron implantation step to create a JFET channel region 96 that extends from source region 74 to drain region 76.

The final steps of the preferred process are shown in FIGURE 4. The photoresist is stripped and a middle-level oxide layer 98 is deposited over the surface of oxide layer 40. Middle-level oxide layer 98 is then densified in a thermal step. A plurality of contact orifices 100 are next patterned and etched into middle-level oxide layer 98. The middle-level oxide layer 98 is then reflowed into the contact orifices 100 to produce sloping sidewalls thereof. A respective orifice 102 in field oxide layer 40 is opened below each contact orifice 100 to expose the surface 42 of the epitaxial layer 38 therebeneath. Metal leads 104-118 are then deposited, patterned and etched according to conventional methodology.

An important aspect of the invention is the existence of a middle level oxide portion 120 that is left over JFET channel 96. Top gate metal lead 117 is patterned and etched not only to contact gate contact region 88, but to extend over channel 96 spaced therefrom by middle level oxide portion 120. The existence of middle level oxide portion 120 allows the achievement of up to 45 volts in operating voltage. The standard (p) channel JFET without middle level oxide portion 120 would only operate up to a limit of approximately 32 to 33 volts because of problems associated with the electric field intensification at the drain/top gate junction. Middle level oxide portion 120 reduces the field intensification that occurs there, and allows the breakdown voltage to be extended out to as much as 50 volts. Middle level oxide portion 120 therefore allows the construction of a 45-volt chip. A passivating nitride layer (not shown) is preferably added thereafter to passivate the exposed surface of the completed integrated circuit.

FIGURE 5 is a greatly enlarged schematic cross sectional view of a capacitor that can be formed during the fabrication process of the other devices above described, with like numbers identifying like structure as appropriate. In a separate area of (p) type semiconductor substrate 10, a deep isolation junction region 121 is implanted with a (p) type dopant at the same time that buried collector region 28 and deep junction isolation regions 36 (FIGURE 1) are implanted. The epitaxial layer 38 is then grown on semiconductor substrate 10 and second oxide layer 40 is grown on epitaxial layer 38. An orifice (not shown) is next opened into oxide layer 40 and a (p) type dopant is deposited on the surface 42 of layer 38 at the same time that the (p) type deposition is performed for shallow junction isolation regions 46 and deep collector region 48 (FIGURE 2). Next, a thermal diffusion step is performed that up-diffuses dopant from region 121 and down-diffuses the dopant deposited on the surface 42 of epitaxial layer 38. This combined up-diffusion and .down-diffusion creates a continuous junction isolation region 122 that extends from epitaxial surface 42 into semiconductor substrate 10.

Prior to the doping/diffusion sequence that creates NPN emitter region 80, VPNP base contact region 84 and JFET gate contact region 88 (FIGURE 3), a polycrystalline silicon layer is deposited, patterned with a photoresist mask, and etched to form a polysilicon electrode 124. Electrode 124 is rendered conductive by a heavy deposition of the (n) type dopant used to create emitter region 80, top gate contact region 88 and VPNP base contact region 84. The diffusion step by which the emitter dopant is diffused into regions 80, 84 and 88 will at the same time cause an oxide layer 126 to grow from the exposed surface of polysilicon electrode 124.

Oxide layer 126 is removed within a central region 128 of the outer polysilicon surface. This central region 128 then has deposited on it a compressive-tension nitride dielectric layer 130 that is patterned and etched using conventional photoresist masking techniques to leave the portion of layer 130 shown.

Middle level oxide layer 98 is deposited, densified, a contact opened therein, and reflowed at the same time that these steps are performed on the middle level oxide layer 98 as shown in FIGURE 4. Finally, an outer metal electrode 132 is deposited, patterned and etched at the same time that metal contacts 104-118 are formed.

In summary, a unified process for the fabrication of a vertical PNP transistor, a (p) channel JFET transistor and a metal/nitride/polysilicon capacitor, as well as conventional vertical NPN transistors and other standard devices used in linear bipolar/JFET integrated circuits, has been shown and described. The unified process eliminates many masking steps and permits increased flexibility in circuit design.

## Claims

1. A process for fabricating a junction field effect transistor (JFET) and a capacitor using a single semiconductor substrate of a first conductivity type, comprising the steps of:
forming a buried region (16) of a first conductivity type at a face of the semiconductor substrate (10);
simultaneously forming at least two deep junction isolation regions at the face to be of the first conductivity type, the first deep junction isolation region (36) formed between a JFET area (19) of the substrate (10) and a capacitor area of the substrate (10), the second junction isolation region (121) formed within the capacitor area;
forming an epitaxial layer (38) of the second conductivity type on the face;
forming an insulator layer (40) on an outer face of the epitaxial layer (38);
up-diffusing dopant to extend the buried region (16) and the deep junction isolation regions (36, 121) into the epitaxial layer (38);
simultaneously forming at least two shallow junction isolation regions of the first conductivity type at the outer face of the epitaxial layer (38), each shallow junction isolation region formed to be continuous with a respective deep junction isolation region (36, 121);
forming a polycrystalline layer including silicon on the insulator layer (40) over the second shallow junction isolation region;
forming a middle-level insulating layer over the polycrystalline layer and the insulating layer (40);
opening orifices in the middle-level insulating layer to the polycrystalline layer and to a region of the insulating layer over a gate contact region (88) of the epitaxial layer (38) in the JFET area (19);
removing the region of the insulating layer to expose the gate contact region (88); and
simultaneously doping the polycrystalline layer and the gate contact region to respectively form a conductive capacitor electrode (124) and a top gate contact.

2. The process of claim 1, wnerein said insulator layer (40) comprises silicon dioxide, the process comprising the further step of thermally growing at least a portion of the insulator layer (40) during said step of up-diffusing dopant.

## Patentansprüche

1. Verfahren zum Herstellen eines Übergangs-Feldeffekttransistors (JFETs) und eines Kondensators unter Verwendung eines einzigen Halbleitersubstrats eines ersten Leitfähigkeitstyps, mit den Schritten:
Bilden einer vergrabenen Zone (16) eines ersten Leitfähigkeitstyps an einer Fläche des Halbleitersubstrats (10),
gleichzeitiges Bilden mindestens zweier tiefer Übergangsisolationszonen an der Fläche, die den ersten Leitfähigkeitstyp aufweisen soll, wobei die erste tiefe Übergangsisolationszone (36) zwischen einem JFET-Bereich (19) des Substrats (10) und einem Kondensatorbereich des Substrats (10) gebildet wird und die zweite Übergangsisolationszone (121) innerhalb des Kondensatorbereichs gebildet wird,
Bilden einer Epitaxieschicht (38) des zweiten Leitfähigkeitstyps auf der Fläche,
Bilden einer Isolatorschicht (40) auf einer Außenfläche der Epitaxieschicht (38),
Aufwärtsdiffundieren eines Störstoffs, um die vergrabene Zone (16) und die tiefen Übergangsisolationszonen (36, 121) in die Epitaxieschicht (38) auszudehnen,
gleichzeitiges Bilden von mindestens zwei flachen Übergangsisolationszonen des ersten Leitfähigkeitstyps an der Außenfläche der Epitaxieschicht (38), wobei jede flache Übergangsisolationszone so gebildet wird, daß sie eine jeweilige tiefe Übergangsisolationszone (36, 121) fortsetzt,
Bilden einer Silicium enthaltenden polykristallinen Schicht auf der Isolatorschicht (40) über der zweiten flachen Übergangsisolationszone,
Bilden einer Mittelebenen-Isolierschicht über der polykristallinen Schicht und der Isolierschicht (40),
Anbringen von Öffnungen in der Mittelebenen-Isolierschicht zur polykristallinen Schicht und zu einer Zone der Isolierschicht über einer Gate-Kontaktzone (88) der Epitaxieschicht (38) im JFET-Bereich (19),
Entfernen der Zone der Isolierschicht, um die Gate-Kontaktzone (88) freizulegen, und
gleichzeitiges Dotieren der polykristallinen Schicht und der Gate-Kontaktzone, um eine leitende Kondensatorelektrode (124) bzw. einen oberen Gate-Kontakt zu bilden.

2. Verfahren nach Anspruch 1, wobei die Isolatorschicht (40) Siliciumdioxid aufweist, wobei das Verfahren den weiteren Schritt des thermischen Aufwachsenlassens mindestens eines Teils der Isolatorschicht (40) während des Schritts des Aufwärtsdiffundierens des Störstoffs aufweist.

## Revendications

1. Procédé pour fabriquer un transistor à jonction à effet de champ (JFET) et un condensateur utilisant un unique substrat semi-conducteur d'un premier type de conductivité, comprenant les étapes suivantes
la formation d'une région enterrée (16) d'un premier type de conductivité sur une face du substrat semi-conducteur (10);
la formation simultanée d'au moins deux régions profondes d'isolation de jonction sur la face destinée à être du premier type de conductivité, la première région profonde d'isolation de jonction (36) formée entre une zone JFET (19) du substrat (10) et une zone de condensateur du substrat (10), la seconde région d'isolation de jonction (121) formée dans la zone de condensateur;
la formation d'une couche épitaxiale (38) du second type de conductivité sur la face ;
la formation d'une couche isolante (40) sur une face extérieure de la couche épitaxiale (38);
la diffusion vers le haut de dopant pour étendre la région enterrée (16) et les régions profondes d'isolation de jonction (36, 121) dans la couche épitaxiale (38);
la formation simultanée d'au moins deux régions peu profondes d'isolation de jonction du premier type de conductivité sur la face extérieure de la couche épitaxiale (38), chaque région peu profonde d'isolation de jonction étant formée pour être respectivement dans la continuité d'une région profonde d'isolation de jonction (38, 121);
la formation d'une couche polycristalline incluant du silicium sur la couche isolante (40) sur la seconde région peu profonde d'isolation de jonction ;
la formation d'une couche isolante de niveau moyen sur la couche polycristalline et la couche isolante (40);
l'ouverture d'orifices dans la couche isolante de niveau moyen vers la couche polycristalline et vers une région de la couche isolante sur une région de contact de grille (88) de la couche épitaxiale (38) dans la zone JFET (19);
la suppression de la région de la couche isolante pour exposer la région de contact de grille (88); et
le dopage simultané de la couche polycristalline et de la région de contact de grille pour former respectivement une électrode capacitive conductrice (124) et un contact supérieur de grille.

2. Procédé selon la revendication 1, dans lequel ladite couche isolante (40) comprend du dioxyde de silicium, le procédé comprenant en outre une étape de croissance thermique d'au moins une portion de la couche isolante (40) durant ladite étape de diffusion vers le haut de dopant.
